# FASCICULE DE BREVET EUROPEEN

(11) **EP 4 082 121 B1**
(45) Date de publication et mention de la délivrance du brevet: **11.10.2023**
(21) Numéro de dépôt: 20829614.5
(22) Date de dépôt: 21.12.2020
(51) Int. Cl.: H04B 1/10, H04B 1/00

(54) **DISPOSITIF RADIOFRÉQUENCE**
HOCHFREQUENZVORRICHTUNG
RADIOFREQUENCY DEVICE

(30) Priorité: 26.12.2019 FR 1915617
(43) Date de publication de la demande: 02.11.2022
(73) Titulaire: THALES, 92400 Courbevoie (FR)
(72) Inventeur: MAILLOUX, Pierre-Yves, 49309 CHOLET (FR); DEMENITROUX, Wilfried, 49309 CHOLET (FR); BERTHOU, Nicolas, 49300 CHOLET (FR)
(74) Mandataire: Atout PI Laplace
(86) Numéro de dépôt international: PCT/EP2020/087519
(87) Numéro de publication internationale: WO 2021/130188

(56) Documents cités:
- US-A1- 2006 057 959
- US-A1- 2012 289 171
- US-A1- 2013 052 973
- US-A1- 2018 367 167

## Description

L'invention concerne une architecture radiofréquence. Elle se situe dans le domaine de l'électronique radiofréquence RF s'étendant de quelques kHz à quelques GHz, dans des postes radiofréquences.

Les postes radiofréquences sont conçus pour fonctionner dans des environnements électromagnétiques denses où plusieurs postes de radiocommunication doivent pouvoir cohabiter. Aujourd'hui, pour répondre à cette contrainte, on intègre sur les modules radiofréquences des fonctions de filtrages. A ces fonctions, on ajoute des étages de transposition de fréquence afin de filtrer efficacement les signaux perturbateurs provenant de postes situés à proximité.

L'un des objectifs d'un récepteur/émetteur radio est :
D'une part de recevoir une grande dynamique de signaux radiofréquences en présence de signaux perturbateurs dont l'éloignement par rapport au signal utile peut aller de quelques dizaines de Hertz à plusieurs dizaines de MHz ; un récepteur radio efficace est capable de recevoir un signal utile de très faible valeur en présence d'un signal perturbateur de forte valeur.

D'autre part, un émetteur radio doit pouvoir émettre un signal utile tout en limitant l'émission de signaux parasites néfastes aux autres postes de communication ; un émetteur radio efficace est capable d'émettre un signal avec une pureté spectrale compatible avec une utilisation multi-émetteurs-récepteurs colocalisés.

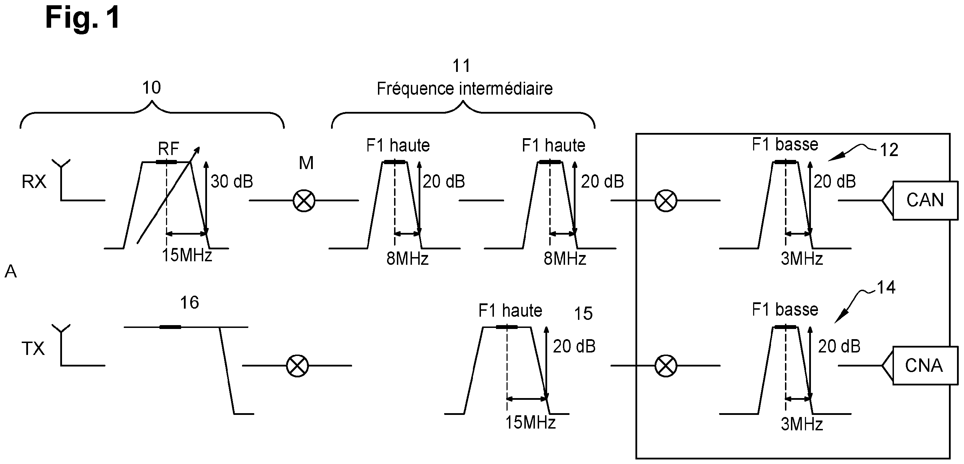

Pour répondre à ces besoins, il est connu d'utiliser une architecture RF superhétérodyne à double conversion basée sur un filtrage étroit utilisant généralement plusieurs filtres à ondes acoustiques de surface ou SAW (Surface Acoustic Wave). Le signal RF que l'on souhaite recevoir ou émettre passe donc dans un étage de fréquence intermédiaire fixe afin de pouvoir filtrer les signaux parasites avec un filtre étroit, comme il est illustré en figure 1. Le signal RF reçu sur une antenne A est tout d'abord filtré par un filtre d'antenne 10 protégeant les étages de la partie avant ou « Front-End », comme l'amplificateur faible bruit ou LNA (Low Noise Amplifier) ou le mélangeur, des non linéarités dues aux signaux perturbateurs. Il est ensuite filtré par un filtre à fréquence intermédiaire 11 filtrant les brouilleurs situés à partir d'une à plusieurs dizaines de MHz du signal utile, puis d'un filtrage à basse fréquence 12 réalisant le complément de filtrage sur les perturbateurs proches, avant de passer dans un convertisseur analogique numérique CAN. De la même manière, en émission, le signal est converti par un convertisseur numérique analogique CNA, suivi d'un étage de filtrage à basse fréquence 14 efficace contre les effets indésirables de la conversion numérique analogique, puis le signal est filtré à travers un filtre haute fréquence 15 permettant le filtrage des signaux parasites proches du signal émis. Il est suivi d'un filtre d'antenne16 efficace contre les non linéarités des amplificateurs de puissance avant émission par l'antenne A.

Une telle structure présente un encombrement qui ne permet pas toujours son installation lorsque les environnements sont contraints et qui présente une consommation élevée des composants.

Une autre solution est décrite dans la demande de brevet US2018367167, figure 2. Le dispositif de radio numérique à canaux multiples proposé comprend une antenne 20, un convertisseur large bande, un groupe de filtres 21 connecté entre l'antenne et le convertisseur large bande 22, lui-même connecté à une unité de traitement 23. Le groupe de filtres comprend plusieurs filtres acoustiques de surface à bande étroite ayant des bandes de fréquences distinctes et répétitives dans une largeur de bande donnée. Chaque bande de fréquences comprend plusieurs canaux distincts. Cette architecture malgré ses avantages offre une faible protection aux signaux perturbateurs.

La demande de brevet US 2012/0289171 divulgue une structure permettant d'étendre la limite de fréquence supérieure des radios ou des émetteurs-récepteurs de communication.

La demande de brevet US 2013/0052973 décrit une structure comprenant un groupe de filtres dont les caractéristiques sont déterminées selon une valeur de fréquence souhaitée.

Dans la suite de la description, l'expression « signaux perturbateurs » désigne des signaux qui vont affecter le fonctionnement de dispositifs.

L'invention repose sur une nouvelle architecture qui va utiliser un bloc d'un émetteur-récepteur RF combiné à une banque de filtres. Cette banque de filtres se trouvera alors entre l'antenne et l'émetteur-récepteur RF désigné aussi sous le terme anglo-saxon « transceiver ». La banque de filtres a notamment pour fonction d'éliminer les signaux perturbateurs en réception et en émission sans utiliser d'étage de fréquence intermédiaire.

L'invention concerne un dispositif radiofréquence comprenant au moins les éléments suivants :
- Une antenne reliée à un premier dispositif de sélection K₁ de la voie d'émission ou de la voie de réception, suivi d'un étage de Front-End dont la sortie est reliée à un deuxième dispositif de sélection K₂ de la voie d'émission ou de la voie de réception, Un groupe de filtres connecté entre le deuxième dispositif de sélection K₂ et un troisième dispositif de sélection K₃ de la voie d'émission ou de la voie de réception, Le troisième dispositif de sélection K₃ est connecté à un émetteur/récepteur,
- L'émetteur/récepteur comprenant une partie convertisseur (CAN, CNA) caractérisé en ce que :
- Le groupe de filtres comprend N filtres ayant des bandes de fréquences B_{N} distinctes dans une largeur de bande donnée B_{T}, le groupe de filtres est relié à un gestionnaire sélectionnant au moins un des filtres Fj du groupe de filtres, afin d'atténuer un premier type de signaux perturbateurs P₁, au voisinage de la fréquence centrale du canal à recevoir,
- L'émetteur/récepteur comprend un étage comprenant un filtre variable, le filtre variable est configuré afin d'éliminer un deuxième type de signaux perturbateurs P₂, ledit étage est connecté entre le groupe de filtres et l'ensemble de conversion analogie-numérique et numérique-analogique,
- Le nombre N de filtres du groupe de filtres est choisi en tenant compte de la valeur de bande de fréquences Bt de fonctionnement de l'antenne, de la valeur d'une largeur de canal Bc choisie et d'un coefficient δ tenant compte des effets de recouvrement.

Les filtres du groupe de filtres sont, par exemple, des filtres configurés pour réaliser une fonction de filtrage étroit dans un encombrement réduit.

Les filtres du groupe de filtres peuvent être choisis dans la liste suivante : filtre à onde acoustiques de surface SAW, filtre à ondes acoustiques de volume BAW.

Les filtres du groupe de filtres sont, par exemple, choisis afin de traiter des signaux compris dans la bande très haute fréquence VHF.

Les filtres du groupe de filtres peuvent être choisis afin de traiter des signaux compris dans la bande ultra haute fréquence UHF.

L'antenne comprend, par exemple, une voie d'émission et une voie de réception.

Le dispositif comporte, par exemple, un filtre d'antenne configuré pour filtrer un signal Sᵣ, un amplificateur adapté à amplifier le signal filtré S₁ avant transmission vers le groupe de filtres, dont un des filtres est sélectionné et activé afin de filtrer d'au moins 30 dB les signaux parasites en émission situés à plus de 10 MHz de la fréquence du filtre, un premier amplificateur adapté à amplifier le deuxième signal filtré S₂, un démodulateur IQ du deuxième signal S₂, un séparateur de phase et une boucle à verrouillage de phase générant un signal mélangé au deuxième signal filtré avant un troisième filtre à fréquence variable dont la fréquence centrale F₃ est choisie afin d'éliminer les signaux perturbateurs de l'ordre de 1 MHz à 10 MHz du canal de réception.

Le dispositif peut comporter une voie d'émission comprenant deux convertisseurs CAN reliés chacun à un premier filtre, à fréquence variable configuré pour filtrer les répliques liées aux convertisseurs, deux amplificateurs, un amplificateur étant connecté à une sortie d'un premier filtre, un séparateur de phase et une boucle à verrouillage de phase délivrant un signal de mélange aux deux signaux issus des amplificateurs, un filtre du groupe de filtres sélectionné et activé par le gestionnaire, afin de filtrer des signaux parasites de +/- 8 MHz à +/- plusieurs centaines de MHz avant transmission à la partie émission de l'antenne.

L'étage de filtrage variable, de modulation/démodulation IQ et les convertisseurs sont par exemple disposés sur un même composant.

D'autres caractéristiques et avantages de la présente invention apparaîtront mieux à la lecture de la description d'un exemple de réalisation donné à titre illustratif et nullement limitatif, annexé des figures qui représentent :
[Fig.1], un plan de filtrage pour un émetteur/récepteur en bande RF selon l'art antérieur,

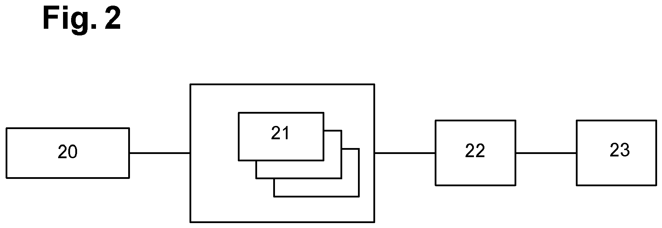

[Fig.2], une architecture connue de l'art antérieur,
[Fig.3], un exemple de synoptique de l'architecture selon l'invention, et
[Fig.4], un exemple de plan de filtrage pour un récepteur en bande UHF.

L'exemple détaillé ci-après est donné à titre illustratif afin de bien faire comprendre l'architecture selon l'invention. L'architecture selon l'invention n'est pas limitée à l'exemple détaillé ci-après. L'invention est applicable à d'autres modes de réalisation qui peuvent être mis en pratique ou réalisés de différentes manières.

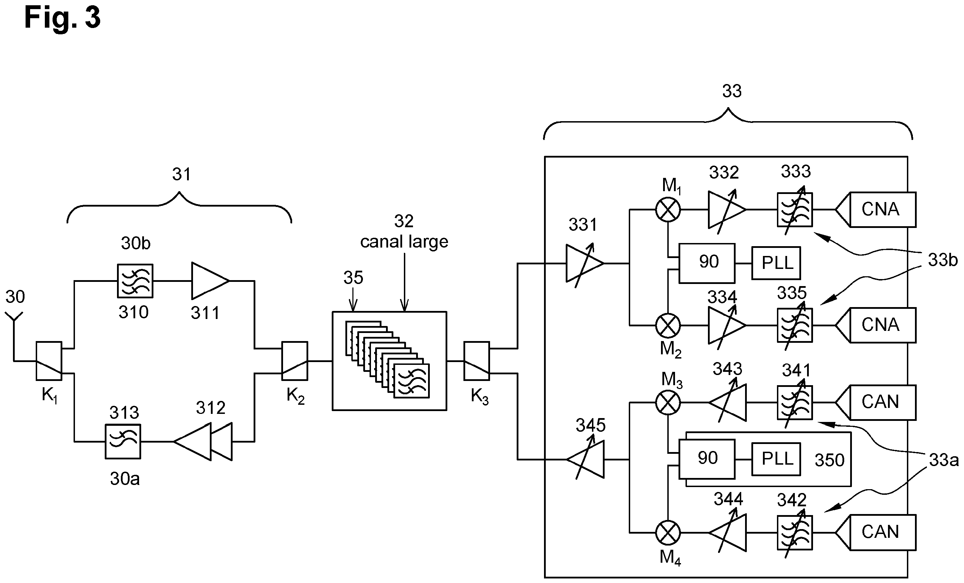

La figure 3 illustre un synoptique d'un exemple d'architecture selon l'invention pour une utilisation monovoie. Le système selon l'invention comporte une antenne de réception et/ou d'émission 30 reliée à un premier dispositif de sélection K₁ de la voie d'émission ou de la voie de réception, suivi d'un étage de Front-End 31 dont la sortie est reliée à un deuxième dispositif de sélection K₂ de la voie d'émission ou de la voie de réception, lui-même relié à un ensemble ou groupe de plusieurs filtres 32, connecté à un dispositif de sélection K₃ de la voie d'émission ou de la voie de réception. Le troisième dispositif de sélection K₃ est connecté à un émetteur-récepteur ou « transceiver » RF, 33, comprenant une voie pour traiter les signaux de réception et une voie pour traiter les signaux à l'émission.

L'antenne 30 comprend une voie d'émission 30b et une voie de réception 30a. Elle est configurée pour recevoir et émettre un rayonnement radiofréquence RF dans une bande de fréquences spécifiée par l'application, qui chevauche au moins en partie les bandes de fréquences du groupe de filtres et les largeurs de bandes des convertisseurs CAN et CNA.

Considérant la voie de réception, un signal Sr est reçu sur l'antenne 30. Le signal est tout d'abord filtré par un filtre d'antenne 310 à une première fréquence F₁, le signal filtré S₁ est ensuite amplifié par un amplificateur 311, avant transmission vers le groupe de filtres 32. Le groupe de filtres comprend N filtres 320₁...320_{N}. A l'instar des filtres utilisés dans les étages de fréquence intermédiaire sur les architectures superhétérodynes, chaque filtre réalise la fonction de filtrage des signaux perturbateurs, atténuant d'au moins 30 dB les signaux qui se trouveraient à environ une dizaine de MHz à plusieurs centaines de MHz du signal utile. La fréquence centrale Fc de chacun des filtres, ainsi que leur bande passante B, permet de couvrir toute la bande de fréquences que l'on souhaite recevoir à l'antenne. Un recouvrement au niveau de la bande passante des filtres est nécessaire afin de recevoir ou émettre dans l'ensemble des canaux. L'étage de fréquence intermédiaire devient alors inutile, la banque de filtres réalisant cette fonction pour toutes les fréquences que l'on souhaite émettre ou recevoir. Le groupe de filtres reçoit une commande d'un gestionnaire 35 qui va sélectionner un filtre à utiliser en fonction du canal que l'on souhaite recevoir ou émettre. Le filtre étant sélectionné et activé à une fréquence centrale F₂, tous les signaux perturbateurs en réception ou tous les signaux parasites en émission qui se trouveront à plus d'une valeur de fréquence donnée α, par exemple, 10 MHz de la fréquence du filtre seront alors filtrés d'au moins β, par exemple 30 dB. Le signal filtré S₂ est transmis au transceiver 33. Le signal filtré S₂ est amplifié dans un premier amplificateur 331. A l'issue de cet amplificateur, le signal S₂ passe par un démodulateur IQ. Il est alors mélangé, M₁, M₂, à un signal S₉₀ issu d'un séparateur de phase et d'une boucle à verrouillage de phase 350, avant d'être transmis à un deuxième amplificateur 332, 334, puis filtré par un troisième filtre à fréquence variable 333, 335, dont la fréquence centrale F₃ sera choisie de façon à éliminer les signaux perturbateurs très proches (de l'ordre de 1MHz à 10 MHz) du canal que l'on souhaite recevoir. Le signal filtré S₃ est ensuite transmis à un convertisseur numérique analogique, CNA.

Le filtre d'antenne 310 est choisi pour fonctionner dans une bande de fréquences [F_{Min}, F_{Max}] déterminée par l'application.

Le nombre N de filtres composant le groupe de filtres est déterminé, par exemple, en tenant compte de la bande totale récepteur Br divisée par la largeur de canal Bc et en multipliant par un coefficient δ, par exemple égal à deux afin de tenir compte des effets de recouvrement, phénomène connu de l'homme du métier qui ne sera pas explicité.

Le groupe de filtres de canal large (banque de filtres SAW) permet de protéger des brouilleurs proches et lointains (~10 MHz à 100 MHz) : ce sont les perturbateurs les plus forts qui nécessitent un filtrage avant de passer dans le transceiver RF.

Le filtrage bande étroite est réalisé par le filtre variable du transceiver RF : ce dernier contient un filtrage analogique réglable permettant de réaliser un filtre étroit pour les perturbateurs très proches (-2MHz à 10 MHz).

Pour illustrer l'architecture selon l'invention un exemple chiffré va être donné pour le fonctionnement en réception.

Considérant une bande totale Bt au niveau du récepteur de [225 MHz-400 MHZ]. Les caractéristiques du premier filtre d'antenne (fréquence centrale, par exemple) sont déterminées de façon à supprimer les signaux perturbateurs présents en dehors de la bande [225 MHz - 400 MHz]. Considérant de plus, que le signal à recevoir se trouve à une fréquence Fs de 260 MHz avec une largeur de bande de 2.5 MHz, le deuxième filtre F₂ sélectionné dans le groupe de filtres est configuré avec une fréquence centrale F_{c2} adaptée à laisser passer le canal 260MHz +/- 1.25 MHz tout en offrant une atténuation de 30 dB à +/- 8 MHZ de 260 MHz, afin d'éliminer les signaux perturbateurs se trouvant entre +/- 8 MHz et plus ou moins plusieurs centaines de MHz. Le troisième filtre variable F₃, est configuré afin d'éliminer les signaux perturbateurs entre +/- 2MHz et +/- 8MHz, par exemple avec un filtre canal étroit, une fréquence centrale F_{c3} fixée à 3MHz et une atténuation 30 dB dans la bande de canal 1MHz.

Les filtres du groupe de filtres sont par exemple des filtres « SAW », ou des filtres « BAW » (ondes acoustiques de volume), ou toute autre technologie permettant de réaliser une fonction de filtrage étroit dans un encombrement réduit.

Lorsque l'architecture fonctionne en émission, les configurations des filtres sont choisies de manière similaire à celle décrite pour le fonctionnement en réception de l'architecture.

Le signal à émettre Sₑ par l'antenne 30, via sa voie d'émission 30a, est transmis en parallèle via deux convertisseurs CAN (convertisseurs analogique-numérique) à deux premiers filtres 341, 342, à fréquences variables situés en parallèle permettant, entre autres, de filtrer les répliques liées à l'utilisation du CNA. Le signal est ensuite amplifié via deux amplificateurs 343, 344, un amplificateur étant connecté à une sortie d'un premier filtre. En sortie d'amplificateurs, les signaux IQ sont mélangés M₃, M₄, à un signal S₉₀ issu d'un séparateur de phase et d'une boucle à verrouillage de phase 350, dans un modulateur IQ avant d'être transmis dans un même amplificateur 345. Le signal recombiné et amplifié est transmis au groupe de filtres 32 dont un des filtres est sélectionné et activé par le gestionnaire 35. Le signal filtré des signaux parasites de +/- 8 MHz à plus ou moins plusieurs centaines de MHz est ensuite transmis à la chaîne d'émission de l'antenne, via les commutateurs K₁, K₂, positionnés pour l'émission, puis amplifié via un premier amplificateur 312, puis filtré par un filtre harmonique 313 avant d'être émis par la partie émission 30a de l'antenne 30.

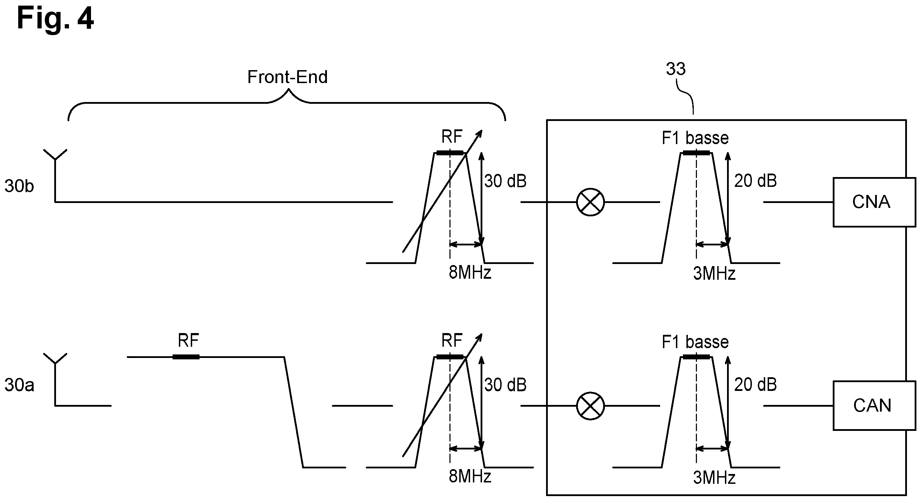

La figure 4 illustre dans sa partie supérieure un exemple de plan de filtrage pour un récepteur en bande UHF et dans la partie inférieure pour un émetteur en bande UHF.

Le signal reçu sur l'antenne après passage dans le filtre d'antenne est filtré à +/- 8 MHz dans un filtre Fⱼ sélectionné dans le groupe de filtres 32 afin d'éliminer un premier type de signaux perturbateurs P₁, puis filtré dans le filtre variable dont la fréquence centrale est fixée à 3 MHz pour supprimer un deuxième type de signaux perturbateurs P₂, plus proches de la fréquence centrale à recevoir, avant d'être transmis au convertisseur numérique analogique CNA.

L'architecture du dispositif radiofréquence selon l'invention peut être utilisée dans le domaine des communications pour la bande UHF, VHF, la bande S, etc.

La partie transceiver (émetteur-récepteur) peut être réalisée sur un même composant de petite taille.

L'architecture selon l'invention utilise une banque de filtres de canal large et un « transceiver » RF. L'architecture ne nécessite plus d'utilisation de PLL, d'étages de fréquences intermédiaires et d'un filtrage « front end » pour les mélanges réciproques/recombinaisons au niveau du mélangeur. Ceci conduit à un gain très important en termes de consommation/encombrement. L'architecture devient alors plus simple et la mise en oeuvre (et donc le coût de mise au point) est alors plus aisée.

## Revendications

1. Dispositif radiofréquence comprenant au moins les éléments suivants :
- une antenne (30), reliée à un premier dispositif de sélection K₁ de la voie d'émission ou de la voie de réception, suivi d'un étage de Front-End (31) dont la sortie est reliée à un deuxième dispositif de sélection K₂ de la voie d'émission ou de la voie de réception,
- un groupe de filtres (32) connecté entre le deuxième dispositif de sélection K₂ et un troisième dispositif de sélection K₃ de la voie d'émission ou de la voie de réception, le troisième dispositif de sélection K₃ est connecté à un émetteur/récepteur (33),
l'émetteur/récepteur (33) comprenant une partie convertisseur analogique numérique et numérique analogique (CAN, CNA) **caractérisé en ce que** :
- le groupe de filtres (32) comprend N filtres ayant des bandes de fréquences B_{N} distinctes dans une largeur de bande donnée B_{T}, le groupe de filtres (32) est relié à un gestionnaire (35) adapté à sélectionner au moins un des filtres Fj du groupe de filtres afin d'atténuer un premier type de signaux perturbateurs P₁, au voisinage de la fréquence centrale du canal à recevoir,
- l'émetteur/récepteur (33) comprend un étage comprenant un filtre variable (333, 335, 341, 342), le filtre variable est configuré afin d'éliminer un deuxième type de signaux perturbateurs P₂, ledit étage est connecté entre le groupe de filtres (32) et l'ensemble de conversion analogique-numérique et numérique-analogique,
- Le nombre N de filtres du groupe de filtres (32) est choisi en tenant compte de la valeur de bande de fréquences Bt de fonctionnement de l'antenne, de la valeur d'une largeur de canal Bc choisie et d'un coefficient δ tenant compte des effets de recouvrement.

2. Dispositif selon la revendication 1 **caractérisé en ce que** les filtres du groupe de filtres (32) sont des filtres configurés pour réaliser une fonction de filtrage étroit dans un encombrement réduit.

3. Dispositif selon la revendication 2 **caractérisé en ce que** les filtres du groupe de filtres sont choisis dans la liste suivante : filtres ondes acoustiques de surface SAW ou filtres ondes acoustiques de volume ou BAW.

4. Dispositif selon la revendication 1 **caractérisé en ce que** les caractéristiques filtres du groupe de filtres sont choisies afin de traiter des signaux compris dans la bande très haute fréquence VHF.

5. Dispositif selon la revendication 1 **caractérisé en ce que** les caractéristiques des filtres du groupe de filtres sont choisies afin de traiter des signaux compris dans la bande ultra haute fréquence UHF.

6. Dispositif selon l'une des revendications 1 à 5 **caractérisé en ce que** l'antenne (30) est une antenne comprenant une voie d'émission (30a) et une voie de réception (30b).

7. Dispositif selon la revendication 1 **caractérisé en ce qu'**il comporte un filtre d'antenne (310) configuré pour filtrer un signal Sᵣ, un amplificateur (312) adapté à amplifier le signal filtré S₁ avant transmission vers le groupe de filtres (32), dont un des filtres est sélectionné et activé afin de filtrer d'au moins 30 dB les signaux parasites en émission situés à plus de 10 MHz de la fréquence du filtre, un premier amplificateur (331) adapté à amplifier le deuxième signal filtré S₂, un démodulateur IQ du deuxième signal S_{2,} un séparateur de phase et une boucle à verrouillage de phase (350) générant un signal mélangé au deuxième signal filtré avant un troisième filtre à fréquence variable (333, 335), dont la fréquence centrale F₃ est choisie afin d'éliminer les signaux perturbateurs de l'ordre de 1MHz à 10 MHz du canal de réception.

8. Dispositif selon la revendication 1 **caractérisé en ce qu'**il comporte une voie d'émission comprenant deux convertisseurs analogiques numériques CAN reliés chacun à un premier filtre (341, 342), à fréquence variable configurés pour filtrer les répliques liées aux convertisseurs, deux amplificateurs (343, 344), un amplificateur étant connecté à une sortie d'un premier filtre, un séparateur de phase et une boucle à verrouillage de phase (350) délivrant un signal de mélange aux deux signaux issus des amplificateurs, un filtre du groupe de filtres (32) sélectionné et activé par le gestionnaire (35) afin de filtrer des signaux parasites de +/- 8 MHz à plus ou moins plusieurs centaines de MHz avant transmission à la partie émission de l'antenne.

9. Dispositif selon l'une des revendications 1 à 6 **caractérisé en ce que** l'étage de filtrage variable, de modulation/démodulation IQ et les convertisseurs sont disposés sur un même composant.

## Patentansprüche

1. Hochfrequenzvorrichtung, mindestens folgende Elemente umfassend:
- eine Antenne (30), die mit einer ersten Auswahlvorrichtung K₁ des Sendekanals oder des Empfangskanals verbunden ist, gefolgt von einer Front-End-Stufe (31), deren Ausgang mit einer zweiten Auswahlvorrichtung K₂ des Sendekanals oder des Empfangskanals verbunden ist,
- eine Filtergruppe (32), die zwischen der zweiten Auswahlvorrichtung K₂ und einer dritten Auswahlvorrichtung K₃ des Sendekanals oder des Empfangskanals verbunden ist, die dritte Auswahlvorrichtung K₃ mit einem Sender/Empfänger (33) verbunden ist,
wobei der Sender/Empfänger (33) einen Analog-Digital- und Digital-Analog-Wandlerteil (ADU, DAU) umfasst, **dadurch gekennzeichnet, dass**:
- die Filtergruppe (32) N Filter mit unterschiedlichen Frequenzbändern B_{N} innerhalb einer gegebenen Bandbreite B_{T} umfasst, die Filtergruppe (32) mit einem Manager (35) verbunden ist, der so angepasst ist, dass er mindestens einen der Filter Fj der Filtergruppe auswählt, um eine erste Art von Störsignalen P₁, in der Nähe der Mittenfrequenz des zu empfangenden Kanals, abzuschwächen,
- der Sender/Empfänger (33) eine Stufe umfasst, die einen variablen Filter (333, 335, 341, 342) umfasst, der variable Filter konfiguriert ist, um eine zweite Art von Störsignalen P₂ zu beseitigen, die Stufe zwischen der Filtergruppe (32) und der Analog-Digital- und Digital-Analog-Wandleranordnung verbunden ist,
- die Anzahl N der Filter der Filtergruppe (32) unter Berücksichtigung des Frequenzbandwerts Bt für den Betrieb der Antenne, des Werts einer gewählten Kanalbreite Bc und eines Koeffizienten δ, der Überlagerungseffekte berücksichtigt, ausgewählt ist.

2. Vorrichtung nach Anspruch 1, **dadurch gekennzeichnet, dass** die Filter der Filtergruppe (32) Filter sind, die so konfiguriert sind, dass sie eine enge Filterfunktion bei geringerem Platzbedarf ausführen.

3. Vorrichtung nach Anspruch 2, **dadurch gekennzeichnet, dass** die Filter der Filtergruppe aus der folgenden Liste ausgewählt sind: Akustische Oberflächenwellenfilter SAW oder Akustische Volumenwellenfilter oder BAW.

4. Vorrichtung nach Anspruch 1, **dadurch gekennzeichnet, dass** die Filtermerkmale der Filtergruppe so gewählt sind, dass sie Signale verarbeiten, die im sehr hohen VHF-Frequenzband umfasst sind.

5. Vorrichtung nach Anspruch 1, **dadurch gekennzeichnet, dass** die Filtermerkmale der Filtergruppe so gewählt sind, dass sie Signale verarbeiten, die im Ultrahochfrequenzband UHF umfasst sind.

6. Vorrichtung nach einem der Ansprüche 1 bis 5, **dadurch gekennzeichnet, dass** die Antenne (30) eine Antenne ist, die einen Sendekanal (30a) und einen Empfangskanal (30b) umfasst.

7. Vorrichtung nach Anspruch 1, **dadurch gekennzeichnet, dass** sie einen Antennenfilter (310) aufweist, der so konfiguriert ist, dass er ein Signal Sᵣ filtert, einen Verstärker (312), der so angepasst ist, dass er das gefilterte Signal S₁ vor der Übertragung an die Filtergruppe (32) verstärkt, von der einer der Filter ausgewählt und aktiviert wird, um im Sendebetrieb Störsignale, die sich mehr als 10 MHz von der Filterfrequenz entfernt befinden, um mindestens 30 dB zu filtern, einen ersten Verstärker (331), der angepasst ist, um das zweite gefilterte Signal S₂ zu verstärken, einen Demodulator IQ des zweiten Signals S₂, einen Phasentrenner und eine Phasenverriegelungsschleife (350), die ein Signal erzeugt, das mit dem zweiten gefilterten Signal vor einem dritten Filter (333, 335) mit variabler Frequenz gemischt ist, dessen Mittenfrequenz F₃ so gewählt ist, dass die Störsignale im Bereich von 1 MHz bis 10 MHz aus dem Empfangskanal beseitigt werden.

8. Vorrichtung nach Anspruch 1, **dadurch gekennzeichnet, dass** sie einen Sendekanal aufweist, der zwei Analog-Digital-Wandler ADU umfasst, die jeweils mit einem ersten Filter (341, 342) mit variabler Frequenz verbunden sind, die so konfiguriert sind, dass sie die mit den Wandlern verbundenen Repliken filtert, zwei Verstärker (343, 344), wobei ein Verstärker mit einem Ausgang eines ersten Filters verbunden ist, einen Phasentrenner und eine Phasenverriegelungsschleife (350), die ein Mischsignal an die beiden Signale aus den Verstärkern liefert, einen Filter der Gruppe von Filtern (32), der vom Manager (35) ausgewählt und aktiviert wird, um Störsignale von +/- 8 MHz bis plus oder minus mehrere Hundert MHz vor der Übertragung an den Sendeteil der Antenne herauszufiltern.

9. Vorrichtung nach einem der Ansprüche 1 bis 6, **dadurch gekennzeichnet, dass** die variable Filterstufe, die IQ-Modulations-/Demodulationsstufe und die Umwandler auf einem einzigen Bauteil angeordnet sind.

## Claims

1. A radiofrequency device comprising at least the following elements:
- an antenna (30), linked to a first transmission channel or reception channel selection device K₁, followed by a front-end stage (31) whose output is linked to a second transmission channel or reception channel selection device K₂,
- a group of filters (32) connected between the second selection device K₂ and a third transmission channel or reception channel selection device K₃, the third selection device K₃ is connected to a transceiver (33),
the transceiver (33) comprising an analogue-digital and digital-analogue converter part (ADC, DAC) **characterised in that**:
- the group of filters (32) comprises N filters having distinct frequency bands B_{N} in a given bandwidth B_{T}, the group of filters (32) is linked to a management device (35) adapted for selecting at least one of the filters Fj of the group of filters in order to attenuate a first type of disturbing signals P₁, in the vicinity of the central frequency of the channel to be received,
- the transceiver (33) comprises a stage comprising a variable filter (333, 335, 341, 342), the variable filter is configured to eliminate a second type of disturbing signals P₂, said stage is connected between the group of filters (32) and the analogue-digital and digital-analogue conversion set,
- the number N of filters of the group of filters (32) is chosen by taking into account the operating frequency band value Bt of the antenna, the value of a selected channel width Bc and a coefficient δ taking into account the overlap effects.

2. The device according to claim 1, **characterised in that** the filters of the group of filters (32) are filters configured to perform a narrow filtering function in a reduced bulk.

3. The device according to claim 2, **characterised in that** the filters of the group of filters are chosen from the following list: surface acoustic wave SAW filters or bulk acoustic wave or BAW filters.

4. The device according to claim 1, **characterised in that** the filter characteristics of the group of filters are chosen in order to process signals comprised in the very high frequency VHF band.

5. The device according to claim 1, **characterised in that** the characteristics of the filters of the group of filters are chosen in order to process signals comprised in the ultrahigh frequency UHF band.

6. The device according to one of claims 1 to 5, **characterised in that** the antenna (30) is an antenna comprising a transmission channel (30a) and a reception channel (30b).

7. The device according to claim 1, **characterised in that** it has an antenna filter (310) configured to filter a signal Sᵣ, an amplifier (312) adapted for amplifying the filtered signal S₁ before transmission to the group of filters (32), of which one of the filters is selected and activated in order to filter by at least 30 dB the spurious signals in transmission situated at more than 10 MHz from the frequency of the filter, a first amplifier (331) adapted for amplifying the second filtered signal S₂, a demodulator IQ of the second signal S_{2,} a phase splitter and a phase locked loop (350) generating a signal mixed with the second filtered signal before a third variable frequency filter (333, 335), of which the central frequency F₃ is chosen in order to eliminate the interfering signals of the order of 1 MHz to 10 MHz from the reception channel.

8. The device according to claim 1, **characterised in that** it has a transmission channel comprising two analogue-digital converters ADC, each linked to a first filter (341, 342), with variable frequency, configured to filter the replicas linked to the converters, two amplifiers (343, 344), one amplifier being connected to an output of a first filter, a phase splitter and a phase locked loop (350) delivering a mixed signal to the two signals originating from the amplifiers, a filter of the group of filters (32) selected and activated by the management device (35) in order to filter spurious signals of +/-8 MHz to plus or minus several hundreds of MHz before transmission to the transmission part of the antenna.

9. The device according to one of claims 1 to 6, **characterised in that** the variable filter and IQ modulation/demodulation stage and the converters are disposed on one and the same component.
